# EUROPÄISCHE PATENTSCHRIFT

(11) **EP 3 715 880 B1**
(45) Veröffentlichungstag und Bekanntmachung des Hinweises auf die Patenterteilung: **11.10.2023**
(21) Anmeldenummer: 19164775.9
(22) Anmeldetag: 23.03.2019
(51) Int. Cl.: G01R 31/11, H04B 3/46, H04L 41/147

(54) **VERFAHREN UND VORRICHTUNG ZUR ERMITTLUNG DES ZUSTANDS EINER ELEKTRISCHEN LEITUNG**
METHOD AND DEVICE FOR DETERMINING THE STATE OF AN ELECTRIC LINE
PROCÉDÉ ET DISPOSITIF DE DÉTERMINATION DE L'ÉTAT D'UN CONDUCTEUR ÉLECTRIQUE

(43) Veröffentlichungstag der Anmeldung: 30.09.2020
(73) Patentinhaber: Lapp Engineering AG, 6330 Cham (CH)
(72) Erfinder: Hilsenbeck, Stefan, 71144 Steinenbronn (DE); Struck, Tobias, 98693 Ilmenau (DE); Möbus, Ralf, 73779 Deizisau (DE); Körner, Werner, 14169 Berlin (DE)
(74) Vertreter: Rutz & Partner

(56) Entgegenhaltungen:
- EP-A1- 2 157 438
- DE-A1- 10 112 844
- DE-A1-102005 055 429
- DE-A1-102010 000 249
- US-B1- 6 657 437

## Beschreibung

Die Erfindung betrifft ein Verfahren und eine Vorrichtung zur Ermittlung des Zustands einer elektrischen Leitung, insbesondere von Schadstellen, welche die Lebensdauer der elektrischen Leitung beeinträchtigen.

Bei der Übertragung elektrischer Signale können die eingesetzten Kabel aufgrund von Einwirkungen aus der Umgebung und Belastungen während des Betriebs der Kabel beschädigt werden. Die Beschädigungen können sowohl durch einmalige mechanische oder chemische Einwirkungen (z.B. durch Schläge, Überfahren oder Reinigung) oder durch kontinuierliche Beanspruchungen (z.B. wiederholte Biege- und/oder Drehzyklen, Umgebungsmedien oder Strahlung) entstehen. Beschädigungen führen nicht zwingend zum vollständigen Ausfall des Kabels. Stattdessen beeinträchtigen Beschädigungen oft die Kabeleigenschaften, die sich über die weitere Lebensdauer kontinuierlich oder sprunghaft verschlechtern. Ausfälle von Kabeln führen zu Betriebsunterbrüchen und damit verbundenen hohen Kosten. Durch eine frühzeitige Erkennung von kleineren und grösseren Beschädigungen an Kabeln können Unterhalts- und Reparaturarbeiten frühzeitig eingeplant und gezielt ausgeführt werden.

Aus der US7960976B1 ist ein Kabel-Testsystem basierend auf der Technologie der Zeitdomänenreflektometrie (Time Domain Reflectometry, TDR) bekannt. Ein TDR-Modul berechnet die korrekte Funktion eines Kabels basierend auf der Amplitude eines Testsignals. Nachteilig hierbei ist, dass nicht alle Arten von Beschädigungen erkannt werden.

Aus der US7245129B2 ist eine Vorrichtung zur Kabeldiagnose bekannt. Hierbei wird ein kompliziert geformter Signalpuls generiert und ausgesendet und ein reflektiertes TDR-Signal ausgewertet, um Diagnoseresultate zu ermitteln.

Aus der EP3249416A1 ist ein Verfahren zur Schadstellenermittlung an elektrischen Kabeln bekannt. Im Nutzbetrieb wird das Übertragungssignal an wenigstens einem Ende der Übertragungsstrecke aufgezeichnet und mittels einer Signalverarbeitungseinrichtung eine Unterscheidung in einen Nutzsignalanteil und einen Reflektionsanteil vorgenommen. Nachteilig hierbei ist, dass nicht alle Schadstellen am elektrischen Kabel mit hoher Zuverlässigkeit ermittelt werden.

Die DE10112844A1 offenbart ein Verfahren zur Online-Prüfung von Feldbus-Einrichtungen, wobei Teilnehmer Daten gemäss einem vorgegebenen Protokoll über eine Feldbusleitung zu einer Prüfeinrichtung übertragen. Dabei wird während einer inaktiven Phase des Protokolls ein Prüfsignal auf die Feldbusleitung gesendet und eine Reflexion des Prüfsignals auf der Feldbusleitung erfasst und ausgewertet.

Die US6657437B1 offenbart ein Verfahren zur Durchführung von Zeitbereichsreflektometrie, bei dem während wiederkehrenden Übertragungen ein Testsignal ausgesendet und eine Reaktion des Netzwerks in Kombination mit den wiederkehrenden Übertragungen erfasst wird und daraus die Signalübertragungseigenschaften des Netzwerks bestimmt werden.

Die EP2157438A1 offenbart ein Verfahren zum Betrieb einer Endeinrichtung an einem für eine Datenübertragung vorgesehenen Kommunikationsmedium, wobei im Anschluss an einen Sendevorgang Reflexionen auf dem Kommunikationsmedium auf das Vorkommen einer vorgegebenen Signatur überwacht werden.

Die DE102010000249A1 offenbart ein Verfahren zum Überprüfen elektrischer Eigenschaften eines Kabels zwischen einer Messstelle, an die eine Messeinrichtung angeschlossen ist und einer Schaltstelle, an die eine Schalteinrichtung angeschlossen ist, wobei ein Messvorgang oder Schaltvorgang fernsteuerbar ist.

Die DE102005055429A1 betrifft ein Verfahren zur Diagnose eines Bussystems mit einer Anzahl von Busteilnehmern, wobei eine portable Diagnoseeinrichtung als ein separater Busteilnehmer über eine Steckverbindung an einer vorgebbaren Position an das Bussystem angeschlossen wird und mittels einer Protokollanalysefunktion mindestens ein physikalischer Parameter und ein logischer Parameter überwacht und gegebenenfalls analysiert werden.

Der Erfindung liegt daher die Aufgabe zu Grunde, ein verbessertes Verfahren sowie eine verbesserte Vorrichtung zur Ermittlung des Zustands elektrischer Leitungen zu schaffen. Das Verfahren soll eine kostengünstige, mit geringem Aufwand durchführbare und zuverlässige Erkennung des Zustands der elektrischen Leitung, insbesondere der Feststellung von Schadstellen ermöglichen.

Insbesondere soll das Verfahren erlauben, die Position der Schadstellen entlang der elektrischen Leitung sowie deren Ausmass zu ermitteln.

Ferner soll das Verfahren eine qualitative Überwachung von Schadstellen ermöglichen, die an elektrischen Leitungen ermittelt wurden.

Weiterhin soll das Verfahren zur Früherkennung und Vorhersage von Ausfällen bzw. zur Angabe der Restlebensdauer der elektrischen Leitungen geeignet sein.

Zudem soll das Verfahren während des Betriebs einer elektrischen Leitung durchführbar sein, ohne dass nachteilige Einwirkungen auf den Betrieb der elektrischen Leitung, gegebenenfalls Störungen der Datenübertragung über die elektrische Leitung auftreten.

Diese Aufgabe wird mit einem Verfahren und einer Vorrichtung gelöst, welche die in Anspruch 1 bzw. Anspruch 11, angegebenen Merkmale aufweisen. Vorteilhafte Ausgestaltungen der Erfindung sind in weiteren Ansprüchen angegeben.

Das Verfahren dient der Zustandsermittlung elektrischer Leitung, insbesondere der Feststellung von Schadstellen, und wird während des Nutzbetriebs, in dem Daten gemäss einem Datenübertragungsprotokoll unidirektional oder bidirektional über die elektrische Leitung übertragen werden, ausgeführt.

Erfindungsgemäss ist vorgesehen,
a) dass gemäss dem Datenübertragungsprotokoll Daten in Datenpaketen gebündelt werden, die in zeitlichen Abständen getrennt voneinander über die elektrische Leitung übertragen werden;
b) dass während den zeitlichen Abständen wenigstens ein Messimpuls über die elektrische Leitung übertragen wird;
c) dass innerhalb eines Zeitfensters Signalanteile des Messimpulses gemessen werden, die an Reflexionsstellen der elektrischen Leitung reflektiert wurden; und
d) dass die reflektierten Signalanteile ausgewertet und für zumindest eine zugehörige Reflexionsstelle ein dazu entsprechender Zustand der elektrischen Leitung bestimmt wird.

Das Verfahren ist an einer elektrischen Leitung anwendbar, die als Datenleitung dient, ohne dass die Datenübertragung unterbrochen werden muss. Messungen des Zustands der elektrischen Leitung und die Ermittlung von Schadstellen erfolgen in zeitlichen Intervallen zwischen Datenpaketen des Nutzsignals. Ebenso können bewusst so viele Datenpakete durch Überlagerung mit Messsignalen geopfert werden, dass die Prozessteuerung innerhalb der eingestellten Kommunikationszykluszeit jederzeit rechtzeitig gültige Datenpakete zur Aktualisierung ihres Prozessabbildes erhält. Diverse aus dem Stand der Technik bekannte Datenübertragungsprotokolle funktionieren auch bei Verlust einzelner oder mehrerer Datenpakete während der Übertragung. Dies wird beim erfindungsgemässen Verfahren dahingehend ausgenutzt, dass der Verlust von Daten soweit in Kauf genommen wird, wie die korrekte Datenübertragung gewährleistet bleibt. Damit kann die Prozessteuerung ihre Steuerungs- und Regelaufgabe trotzdem unterbrechungsfrei durchführen. Das erfindungsgemässe Verfahren nutzt daher Freiräume des fehlertoleranten Datenübertragungsprotokolls, um in diesen Freiräumen die Messung der elektrischen Leitungen durchzuführen.

In einer bevorzugten Ausgestaltung ist vorgesehen, dass während zeitlichen Abständen einer Vielzahl von Datenpaketen je wenigstens ein Messimpuls über die elektrische Leitung übertragen und je innerhalb eines Zeitfensters an Reflexionsstellen der elektrischen Leitung reflektierte Signalanteile des Messimpulses gemessen werden. Die elektrische Leitung kann somit unterbruchsfrei betrieben werden.

In einer weiteren bevorzugten Ausgestaltung werden die Laufzeiten der reflektierten Signalanteile gemessen und die Positionen zumindest der relevanten Reflexionsstellen bestimmt. Hierdurch ist die Position von Schadstellen innerhalb der elektrischen Leitung bestimmbar.

In einer weiteren Ausgestaltung werden für reflektierte Signalanteile, für die das Überschreiten eines Schwellenwerts festgestellt wird, die Laufzeiten gemessen und die zugehörigen Positionen der relevanten Reflexionsstellen bestimmt. Hierdurch werden zukünftige Problemstellen ermittelt.

In einer besonders bevorzugten Ausgestaltung liegt die Länge der Messimpulse in einem Bereich von 5ns - 50ns. Vorzugsweise wird zumindest die Amplitude der reflektierten Signalanteile gemessen.

In einer weiteren vorzugsweisen Ausgestaltung ist vorgesehen, dass das Messverfahren und das Datenübertragungsverfahren zumindest für eine Zeitperiode in der eine Messung der elektrischen Leitung durchgeführt wird und Messimpulse gesendet werden, miteinander synchronisiert sind.

In einer weiteren vorzugsweisen Ausgestaltung ist vorgesehen, dass die Änderung der reflektierten Signalanteile für jede Reflexionsstelle über den Gesamtverlauf der elektrischen Leitung gemessen wird.

Erfindungsgemäss wird aus den gemessenen reflektierten Signalanteilen oder aus den gemäss Datenübertragungsprotokoll übertragenen Daten oder aus Parametern der Datenübertragungseinrichtung wenigstens ein zweiter Messwert abgeleitet. Vorzugsweise wird die Signalgüte und/oder die Bitfehlerrate der übertragenen Daten und/oder eine Stellgrösse eines Filters oder eines Regenerators verwendet, die zur Bearbeitung oder Aufbereitung der übertragenen Daten dienen.

Erfindungsgemäss werden daher nicht nur die Freiräume des Datenprotokolls genutzt, um während der Datenübertragung den Zustand der elektrischen Leitung zu prüfen. Zusätzlich werden die übertragenen Daten geprüft, um eine qualitative Aussage über den Zustand der elektrischen Leitung machen zu können.

Das erfindungsgemässe Verfahren vereinigt somit Prüfmechanismen auf der physikalischen Schicht und der Datensicherungsschicht des Datenübertragungssystems. Diese beiden untersten Schichten des OSI-Modells sind z.B. in https://de.wikipedia.org/wiki/OSI-Modell beschrieben.

Die physikalische Schicht (Physical Layer) hat als einzige einen direkten Kontakt zum physikalischen Übertragungsmedium, d. h. zur elektrischen Leitung. Durch Übertragung von Messpulsen und Auswertung der reflektierten Signalanteile wird diese physikalische Schicht ausgemessen.

Die Aufgabe der Sicherungsschicht (Data Link Layer) ist das Erkennen und ermöglicht das beheben von Übertragungsfehlern. Dazu wird eine gewisse Redundanz in Form von Kontrollinformationen der zu übertragenen Daten in die Datenpakete eingefügt, mit deren Hilfe Bitfehler bis zu einer gewissen Anzahl erkannt und korrigiert werden können. Wird die Fehlerrate aufgrund von Mängeln der elektrischen Leitung zu hoch, ist keine Kommunikation mehr möglich.

Werden Datenpakete in elektrische, digitale Signale gewandelt und mittels elektrischen Leitungen oder Kabeln zu einem anderen Teilnehmer übertragen, bewirken die Leitungskapazitäten und Leitungsinduktivitäten Pulsanstiegs- und Pulsabfallzeiten beim Übergang von einer logischen "0" zu einer logischen "1" und umgekehrt. Besonders bei der Verwendung von grossen Leitungslängen kommt an der Datensenke kein rechteckiger und somit digitaler, sondern ein eher "verschliffener" Spannungsverlauf an. Dieses analoge und teilweise mit Rauschen behaftete Signal muss gefiltert und rekonstruiert werden. Dies geschieht üblicherweise in digitalen Signal Prozessoren mit vorgeschaltetem A/D-Wandler. Wird eine elektrische Leitung äusseren Einflüssen, wie mechanischer Belastung, erhöhte Temperatur oder Störeinstrahlung z.B. von Frequenzumrichtern ausgesetzt, findet eine zusätzliche Verschlechterung des zu übertragenden Signals statt. Der digitale Signalprozessor muss dann die Filtertiefe erhöhen, um die Signale wieder zu rekonstruieren und zu digitalisieren. Ausserdem ist üblicherweise ein Anstieg der Bitfehlerrate zu beobachten. Aus der Bitfehlerrate und der Gesamtanzahl ankommender Bits kann zusätzlich ein Wert für die Signalqualität, insbesondere ein Signal-Rausch-Verhältnis abgeschätzt werden.

Durch die erfindungsgemässe Vereinigung der Prüfmechanismen auf zwei Ebenen des OSI-Protokolls resultiert eine signifikante Erhöhung der Zuverlässigkeit bei der Erkennung, Analyse und Bewertung von Schadstellen sowie bei der Prognose der Restlebensdauer der elektrischen Leitung.

Diese präzisen Informationen zum Zustand der elektrischen Leitung erlaubt, die elektrischen Leitungen optimal bis zum Ende der Betriebslebensdauer zu nutzen und geeignete Massnahmen zu treffen, um die Betriebsbereitschaft der elektrischen oder elektromechanischen Vorrichtungen des Anwenders zu gewährleisten. Dabei erlauben die präzisen Informationen über den Zustand der Leitungen z.B. auch eine elektrische Leitung, die hohen Belastungen ausgesetzt ist, an einer Stelle einzusetzen, an der geringere Belastungen auftreten, falls erste Schadstellen ermittelt wurden.

Das erfindungsgemässe Verfahren ist zur Zustandsprüfung beliebiger elektrischer Leitungen geeignet. Besonders vorteilhaft ist das erfindungsgemässe Verfahren bei Feldbus-Anwendungen geeignet, bei denen Daten über weite Entfernungen übertragen werden, und bei denen hohe Belastungen der elektrischen Leitungen auftreten. Insbesondere ist das Verfahren zur kontinuierlichen Überwachung von bewegten Datenleitungen oder Datenkabeln an oder in industriellen Maschinen und Anlagen geeignet.

Das Verfahren ermöglicht eine vorausschauende Wartung durch Vorhersage von Ausfalls-, Verschleiss- und Alterungserscheinungen. Das Wartungs- oder Prognosesignal ist hierbei eine mathematische Funktion und wird aus dem Messwertverlauf der reflektierten Signalanteile bei der Messung der physikalischen Schicht und vorzugsweise wenigstens einem Messwertverlauf von Sicherungsdaten oder Qualitätsdaten der Datensicherungsschicht gebildet. Die Messwertverläufe werden vorzugsweise synchron über mehrere Messperioden aufgezeichnet. Innerhalb der Intervalle zwischen Datenpaketen erfolgt die Sammlung von Messwerten für die physikalische Schicht. Insbesondere durch Auswertung mehrerer Datenpakete erfolgt die Sammlung von Messwerten für wenigstens einen Qualitätsparameter für die Datensicherungsschicht.

Die Auswertung der beiden Messwertverläufe der physikalischen Schicht und der Datensicherungsschicht erlaubt eine präzise Zustandsbestimmung der elektrischen Leitung. Insbesondere wird die Anzahl sogenannter »false positives« und »false negatives«, die in beiden Fällen kritische Folgen nach sich ziehen können, deutlich gesenkt https://en.wikipedia.org/wiki/False positives and false negati ves.

Bei »false positives«, wird z.B. durch reflektierte Signalanteile mit kleiner Amplitude ein guter Zustand der elektrischen Leitung gemeldet, obwohl die Leitung zur Datenübertragung nicht mehr geeignet ist. Durch Berücksichtigung von Informationen der Datensicherungsschicht kann hingegen festgestellt werden, dass eine fehlerfreie Datenübertragung nicht mehr gewährleistet ist. Unter Berücksichtigung der Stellgrössen der Regeneratoren kann gegebenenfalls auch festgestellt werden, dass diese bereits am Anschlag sind und eine weitere Verschlechterung der Signalqualität nicht mehr kompensieren können.

Bei »false negatives«, wird z.B. durch reflektierte Signalanteile mit grosser Amplitude ein schlechter Zustand der elektrischen Leitung gemeldet, obwohl die Leitung zur Datenübertragung noch immer geeignet ist. Durch Berücksichtigung von Informationen der Datensicherungsschicht kann in diesem Fall festgestellt werden, dass die Datenübertragung noch immer gewährleistet ist und die Signalgüte hoch und die Bitfehlerrate tief ist.

Die Signalverläufe der ersten und zweiten Messwerte sowie der Verlauf des Prognosesignals, das erfindungsgemäß zeitkontinuierlich berechnet wird, werden in vorzugsweisen Ausgestaltungen je mit einem Schwellwert verglichen. Bei Überschreitung eines ersten Schwellenwerts, wird z.B. angezeigt, dass die Amplituden der reflektierten Signalanteile einen zulässigen Wert überschritten haben. Bei Unterschreiten eines zweiten Schwellenwerts wird z.B. angezeigt, dass die Signalgüte der übertragenen Signale ungenügend ist. Durch Vergleich des Prognosesignals kann z.B. angezeigt werden, dass die elektrische Leitung das Ende der Lebensdauer erreicht hat. Somit ist es möglich, einen Status der zu überwachenden elektrischen Leitung, ähnlich einer Ampel, bereitzustellen. Dieser Status kann insbesondere über farbige LEDs oder über einen Bildschirm angezeigt werden.

Um eine Alterung der elektrischen Leitung festzustellen, wird vorzugsweise nach Anlagenerstellung eine Initialmessung vorgenommen. Diese wird als Referenz behandelt und mit den Messungen während des Betriebs verglichen und ausgewertet.

Das erfindungsgemässe Verfahren ist durch eine ebenfalls erfindungsgemässe Messvorrichtung durchführbar. Die Messvorrichtung, welche die Elektronik sowie eine darauf ablaufende Software enthält, wird vorzugsweise zwischen zwei beliebige Datenleitungen oder in einen freien Knotenpunkt in Serie (Daisy Chain) gesteckt. Die Messvorrichtung kann auch endseitig an eine elektrische Leitung angeschlossen werden und gegebenenfalls in die dort vorgesehene Vorrichtung integriert werden.

Die Messvorrichtung umfasst vorzugsweise eine Messschaltung mit einer Steuereinheit, mittels der eine Sendeeinheit zur Abgabe der Messimpulse steuerbar ist und mittels der von einer Empfangseinheit übertragene reflektierte Signalanteile auswertbar sind. Dazu verfügt die Steuereinheit vorzugsweise über einen Mikroprozessor, mittels dessen insbesondere der Messerlauf steuerbar ist und/oder einen Signalprozessor, mittels dessen insbesondere die empfangenen reflektierten Signalanteile auswertbar sind.

Vorzugsweise ist die Steuereinheit oder eine Transfereinheit zur Auswertung der gemäss dem Datenübertragungsprotokoll übertragenen Daten und zur Ermittlung von Messwerten bezüglich der Signalqualität geeignet. Die Steuervorrichtung kann daher die Messwerte für die physikalische Schicht bzw. die elektrische Leitung und die Datensicherungsschicht des OSI-Modells ermitteln. Auch die Erstellung und Auswertung der Messwertverläufe sowie die Vergleiche mit den Schwellen werden kann in der Steuereinheit vollzogen werden.

Die Messvorrichtung ist vorzugsweise drahtlos oder drahtgebunden mit einem zentralisierten Rechner, wie einem Personalcomputer oder einer Datenbank verbunden, in denen Teile der Messprozesse ablaufen bzw. Messdaten und Messreihen sowie Erfahrungswerte abgespeichert werden können.

In einer bevorzugten Ausgestaltung umfasst die Messvorrichtung einen Bildschirm zur Anzeige einer graphischen Benutzeroberfläche.

In vorzugsweisen Ausgestaltungen ist die Messvorrichtung vorzugsweise derart ausgestaltet, dass mehrere elektrische Leitungen gleichzeitig nach dem erfindungsgemässen Verfahren geprüft werden können.

Nachfolgend wird die Erfindung anhand von Zeichnungen näher erläutert. Dabei zeigt:

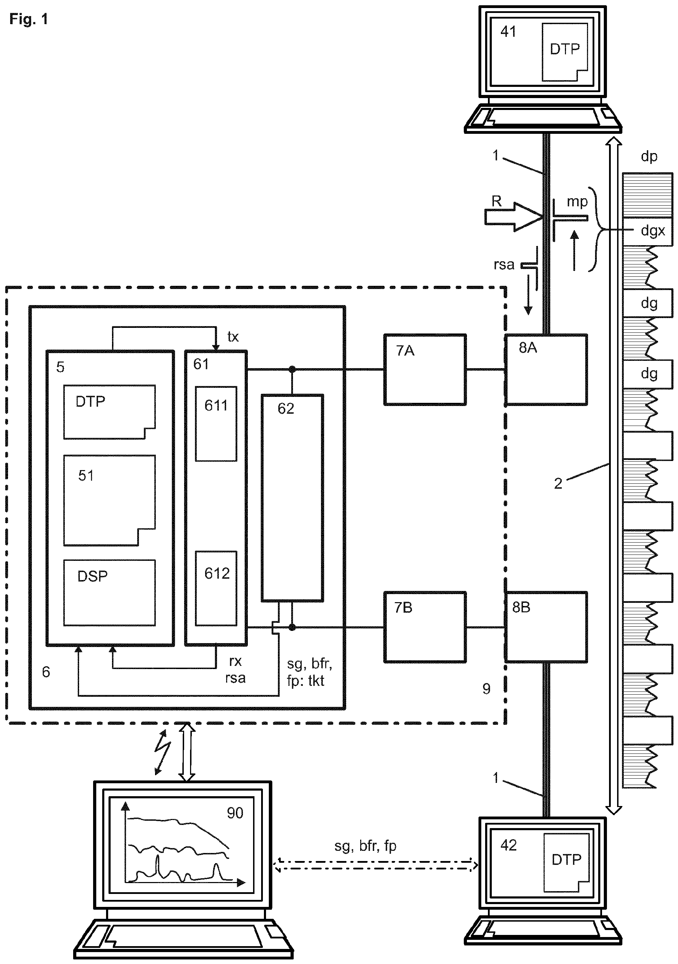

- Fig. 1: eine erfindungsgemässe Messvorrichtung 9, mittels der der Zustand einer elektrischen Leitung 1 geprüft wird, über die Daten zwischen 2 Datenendgeräten 41, 42 übertragen werden; und

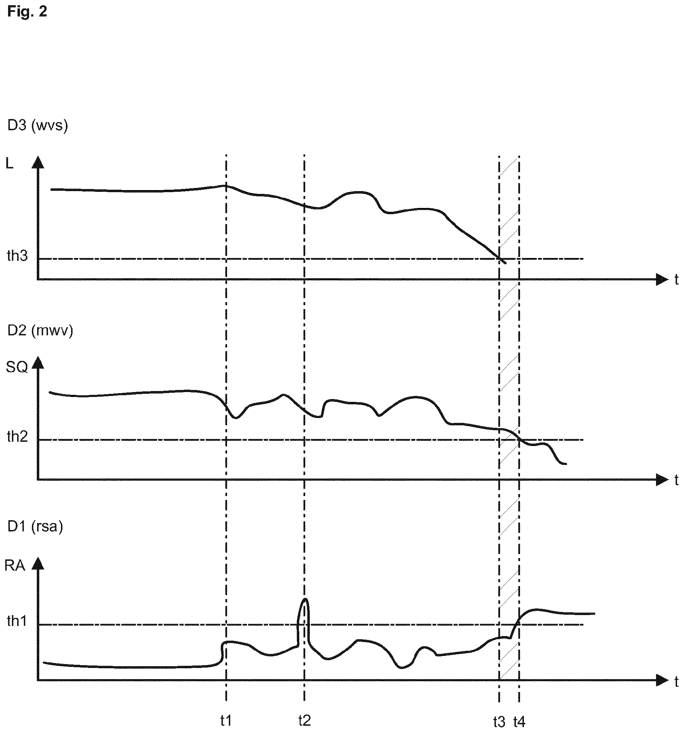

- Fig. 2: ein erstes Diagramm D1 mit dem zeitlichen Verlauf von ersten Messwerten bzw. reflektierten Signalanteilen rsa, ein zweites Diagramm D2 mit dem zeitlichen Verlauf von zweiten Messwerten bzw. einen Messwertverlauf mwv insbesondere mit Messwerten der Datensicherungsschicht, sowie den Verlauf eines Wartungs- und Prognosesignals wvs, das aus den ersten und zweiten Messwerten und/oder den Verläufen der ersten und zweiten Messwerte bestimmt wird.

Fig. 1 zeigt in einer schematischen Darstellung eine elektrische Leitung 1, die zwei elektrische Geräte 41, 42 miteinander verbindet. Auf einer Seite kann beispielsweise ein Steuergerät vorgesehen sein, welches Steuersignale über die elektrische Leitung 1 zu einer Maschine überträgt. Die Maschine bewegt sich z.B. in einem Arbeitsumfeld, weshalb die elektrische Leitung 1 einerseits mechanischen Belastungen, wie Zugbelastungen, Bewegungen und Torsion, und andererseits mechanischen und chemischen Belastungen unterworfen ist, die Schäden und Reflexionsstellen an der elektrischen Leitung verursachen können.

Zur Erläuterung der Erfindung sind exemplarisch ein erstes und ein zweites Datenendgerät 41; 42 an die elektrische Leitung 1, die z.B. als Datenleitung dient, angeschlossen.

Über die elektrische Leitung bzw. die Datenleitung 1 werden vom ersten Datenendgerät 41 digitale Daten in Datenpaketen, die durch zeitliche Abstände oder Intervalle dg voneinander getrennt sind, zum zweiten Datenendgerät 42 übertragen. Die Datenübertragung erfolgt nach einem Datenübertragungsprotokoll DTP. Der Datenstrom 2 ist in Fig. 1 durch einen Pfeil symbolisiert. Die Sequenz der Datenpakete dp und der Intervalle dg ist ebenfalls symbolisch gezeigt. Ferner ist symbolisch dargestellt, dass an einer Schadstelle bzw. Reflexionsstelle R die Datenpakete dp einer störenden Veränderung unterworfen werden.

Im zweiten Datenendgerät 42, welches nach demselben Datenübertragungsprotokoll DTP arbeitet, werden die übertragenen Daten regeneriert. Vorzugsweise wird zusätzlich die Qualität des empfangenen Signals bestimmt. Z.B. werden die Signalgüte und die Bitfehlerrate (siehe https://de.wikipedia.org/wiki/Bitfehlerhäufigkeit) ermittelt. Der Wert der Signalgüte wird z.B. ermittelt, indem geprüft wird, wie stark das empfangene Signal von einem Erwartungswert abweicht. Zur Regeneration der Daten werden z.B. Filter eingesetzt, deren aktuelle Parameter ebenfalls die Signalqualität widerspiegeln. Die Signalgüte, die Bitfehlerrate und die Filterparameter erlauben daher einen Rückschluss auf die Signalqualität der übertragenen Signale und Daten und somit auf die Qualität der elektrischen Leitung 1.

Zur Ermittlung des Zustandes der elektrischen Leitung 1, allfälliger Schadstellen und Veränderungen derselben, ist eine erfindungsgemässe Messvorrichtung 9 an die elektrische Leitung 1 angeschlossen. In diesem Ausführungsbeispiel ist die Messvorrichtung 9 etwa in der Mitte der elektrischen Leitung 1 angeordnet, die in zwei Teile aufgetrennt ist, die je über eine Steckbuchse 8A; 8B an die Messvorrichtung 9 angeschlossen sind. Wie dies in Fig. 1 schematisch gezeigt ist, wird der Datenstrom durch die Messvorrichtung 9 nicht unterbrochen. Die Messvorrichtung 9 kann auch an einem Ende an die elektrische Leitung 1 angeschlossen und z.B. in das erste oder zweite Datenendgerät 41, 42 integriert sein.

Die Steckbuchsen 8A; 8B sind über Pegelwandler 7A; 7B an eine Messschaltung 6 angeschlossen, die vorzugsweise in der Ausgestaltung eines vollintegrierten Netzwerkkontrollers vorliegt.

Die Messschaltung 6 umfasst eine Steuereinheit 5 vorzugsweise in der Ausgestaltung eines Mikrocontrollers oder eines digitalen Signalprozessors DSP (siehe https://de.wikipedia.org/wiki/Digitaler Signalprozessor). Die Steuereinheit 5 kann auch einen Mikroprozessor, in dem ein Messprogramm 51 implementiert ist, und einen Signalprozessor aufweisen, mittels dessen die empfangenen Testsignale verarbeitet werden. Ferner ist ein Transceiver 61 vorgesehen, der eine Sendeeinheit 611 und eine Empfangseinheit 612 umfasst. Mittels des Transceivers 61 können Messimpulse mp ausgesendet und reflektierte Signalanteile rsa empfangen werden. Die reflektierten Signalanteile rsa werden in der Steuereinheit 5 ausgewertet.

Die Messschaltung 6 umfasst ferner ein Transfermodul 62, mittels dessen sichergestellt wird, dass der Datenstrom 2 nicht unterbrochen wird. Im Transfermodul 62 kann ferner die Signalqualität geprüft werden. Dazu können die Signalgüte sg, die Bitfehlerrate bfr und gegebenenfalls Parameter fp eines Filters oder Signalregenerators ermittelt und zur Steuereinheit 5 zur Auswertung übergeben werden. Ferner können im Transfermodul 62 Taktsignale tkt für Intervalle dg erzeugt werden, in denen der Datenstrom 2 keine Datenpakete dp enthält. Erfindungsgemäss wird innerhalb dieser zeitlichen Abstände bzw. Intervalle dg jeweils wenigstens ein Messeimpuls mp ausgesendet und reflektierte Signalanteile rsa empfangen. Verfahren zur Regeneration von digitalen Daten sowie zur Ermittlung der Signalgüte des empfangenen Signals sind z.B. in EP0576919A1 beschrieben.

In Fig. 1 ist illustriert, dass im Intervall dgx von der Sendeeinheit 611 ein Messimpuls mp ausgesendet wurde, der an der Reflexionsstelle R teilweise reflektiert wurde. Die reflektierten Signalanteile rsa werden in der Empfangseinheit 612 empfangen und gegebenenfalls nach Verstärkung der Steuereinheit 5 zur Auswertung übergeben. Der Prozess des Aussendens des Messimpulses mp und des Empfangs der reflektierten Signalanteile rsa erfolgt gesteuert vom Messprogramm 51 innerhalb eines Zeitfensters, welches dem Intervall dgx entspricht oder kleiner ist.

In der Steuereinheit 5 sind vorzugsweise Informationen zum Datenübertragungsprotokoll DTP abgespeichert, sodass Informationen zur Grösse der Zeitintervalle dg zwischen zwei Datenpaketen dg vorliegen. Die Steuereinheit 5 kann die Messungen daher synchron zur Übertragung der Datenpakete dp vom ersten zum zweiten Datenendgerät 41, 42 laufen lassen. Von der Steuereinheit 5 können daher zeitrichtig Steuersignale tx an die Sendeeinheit 611 übermittelt werden, welche Messimpulse mit entsprechender Form bzw. Amplitude und Zeitdauer abgibt. Gleichzeitig können zeitrichtig Empfangssignale rx bzw. reflektierte Signalanteile rsa von der Empfangseinheit 612 empfangen werden.

Die reflektierten Signalanteile rsa werden ausgewertet, um Zustandsdaten für die elektrische Leitung 1 zu ermitteln. Aufgrund der reflektierten Signalanteile rsa können die Position der Schadstelle und deren Ausmass ermittelt werden. Mit höherem Reflexionsgrad und somit höherer Amplitude der reflektierten Signalanteile rsa wird auf einen höheren Leitungsschaden geschlossen. Durch Messung der Signallaufzeit kann die Position der Schadstelle R ermittelt werden. Durch Überwachung des Verlaufs der Veränderung der reflektierten Signalanteile rsa mit dieser Laufzeit kann z.B. anhand von Erfahrungswerten geschätzt oder extra poliert werden, wann ein kritischer Zustand erreicht ist, an dem die elektrische Leitung nicht mehr funktionsfähig ist und ausgetauscht werden muss.

Die Datenauswertung kann allein in der Steuereinheit 5 oder Hilfe eines Rechners 90, z.B. eines Personalcomputers, erfolgen. Vorzugsweise erfolgt eine Aufgabenteilung mit Verarbeitung der reflektierten Signalanteile rsa in der Steuereinheit 5, gegebenenfalls dem darin vorgesehenen Signalprozessor DSP, und die Überwachung des der Veränderungen der reflektierten Signalanteile rsa bzw. der Schadstellen durch den Rechner 90.

Die Überwachung der elektrischen Leitung 1 mittels Messimpulsen mp und Auswertung reflektierter Signalanteile rsa gewährleistet für sich allein bereits eine sehr zuverlässige Überwachung der elektrischen Leitung 1. Hingegen kann die Zuverlässigkeit der Überwachung durch synchrone Überwachung der reflektierten Signalanteile rsa und der Signalqualität der unidirektional oder bidirektional zwischen den Datenendgeräten 41, 42 über die elektrische Leitung 1 übertragenen Daten wesentlich erhöht werden.

In der Steuereinheit 5 werden daher vorzugsweise zwei oder mehrere Messreihen oder Messverläufe gebildet und einzeln sowie in Kombination ausgewertet. Dabei ist es möglich, dass die eine oder andere Messreihe z.B. nach Vergleich mit einem Schwellenwert ein Versagen der elektrischen Leitung 1 anzeigt. Die Messreihen können hingegen auch kombiniert werden, um einen kombinierten Signalverlauf zu bilden, welcher wiederum mit wenigstens einem Schwellenwert verglichen wird, welcher eine kritische Zustandsänderung der elektrischen Leitung anzeigt. Zusätzlich können innerhalb der Messverläufe auch kritische Muster detektiert werden, welche den aktuellen Zustand der elektrischen Leitung 1 oder den zu erwartenden Zustandsverlauf der elektrischen Leitung eines anzeigt. Z.B. verweist ein starker Anstieg der Amplituden der reflektierten Signalanteile rsa auf eine erhebliche mechanische Beschädigung. Aufgrund der erheblichen Beschädigung ist mit einem baldigen Ausfall der elektrischen Leitung 1 zu rechnen, obwohl die Signalgüte der übertragenen Daten möglicherweise noch hoch ist. Falls hingegen bei relativ geringen Amplituden der reflektierten Signalanteile bereits hohe Bitfehlerraten auftreten, oder die Parameter und Stellgrössen der Filter oder Regeneratoren bereits im Endbereich liegen, ist ebenfalls mit einem baldigen Ausfall zu rechnen. Die Informationen der beiden oder mehreren Messreihen ergänzen sich daher ideal. Unter Berücksichtigung der Messreihen sind insbesondere präzisere Prognosen zur verbleibenden Lebensdauer der elektrischen Leitung 1 möglich. D.h., die elektrischen Leitungen 1 können länger genutzt werden, wodurch sich Wartungsaufwendungen und Materialaufwendungen reduzieren.

In einer ersten Messreihe kann der Signalverlauf, z.B. der Amplitudenverlauf, der reflektierten Signalanteile rsa registriert werden. In einer weiteren Messreihe oder einem weiteren Messverlauf kann der Verlauf z.B. der Signalgüte, der Bitfehlerrate oder der Verlauf von Stellgrössen oder Parametern eines Filters oder des Signalregenerators registriert werden. Es liegen daher wenigstens zwei Messreihen oder Messverläufe vor, die vorzugsweise synchron zueinander aufgenommen wurden und einander entsprechen.

Der erste Messverlauf mit den ersten Messwerten bzw. mit den reflektierten Signalanteilen wurde durch Abtastung der physikalischen Schicht der elektrischen Leitung 1 mit Messimpulsen mp ermittelt bzw. erstellt. Die elektrische Leitung 1 bildet die erste Schicht des eingangs genannten OSI-Modells bzw. die physikalische Schicht.

Der zweite Messverlauf mit den zweiten Messwerten bzw. mit den Angaben zur Signalgüte und/oder zur Bitfehlerrate und/oder mit Angaben zu Stellgrössen und Parametern der Filter und Regeneratoren der elektrischen Leitung betrifft die zweite Schicht des OSI-Modells. Der von elektrischen Leitung bzw. der ersten Schicht 1 abgehobene Datenverlauf ist daher mit 2 bezeichnet.

Fig. 2 zeigt in einem ersten Diagramm D1 einen zeitlichen Verlauf der Amplitude A der reflektierten Signalanteile rsa.

Ein zweites Diagramm D2 zeigt einen Messwertverlauf mwv für einen Qualitätswert SQ der zwischen den Datenendgeräten 41, 42 übertragenen Daten. Der betreffende Messwert zur Signalqualität wird z.B. im Transfermodul 62 oder in einem der Datenendgeräte 41, 42 ermittelt und zur Steuereinheit 5 oder zum Personalcomputer 90 übertragen. Beispielsweise betrifft der gezeigte Messwertverlauf mwv den Verlauf der Signalgüte, den Verlauf der Bitfehlerrate oder den Verlauf eines Parameters oder einer Stellgrösse eines Filters oder Regenerators, dem die zwischen den Datenendgerät 41, 42 übertragenen Daten zugeführt werden.

Ein drittes Diagramm D3 zeigt ein den zeitlichen Verlauf Wartungs- und Prognosesignals wvs bzw. die erwartete restliche Lebensdauer L der elektrischen Leitung. Dieser Verlauf wvs wird, aus den reflektierten Signalanteilen rsa und dem Messwertverlauf mwv berechnet, wobei bestimmte Kurvenmuster vorzugsweise ermittelt und zusätzlich berücksichtigt werden.

Für alle drei Diagramme D1, D2, D3 sind Schwellwerte th1, th2, th3 eingezeichnet, nach deren Unterschreiten oder Überschreiten eine Aktion ausgelöst werden soll, sofern das betreffende Unterschreiten oder Überschreiten nicht nur sporadisch ist.

Der Verlauf der Amplitude der reflektierten Signalanteile rsa ist bis zu einem Schadenszeitpunkt t1 weitestgehend konstant. Durch den Schaden steigt zum Zeitpunkt t1 die Amplitude der reflektierten Signalanteile rsa stark an. Gleichzeitig fällt die Kurve für den Messwertverlauf mwv stark ab.

Der Verlauf des Wartungs- und Prognosesignal wvs, das anhand des Verlaufs der reflektierten Signalanteilen rsa und des Messwertverlaufs mwv errechnet wird, verläuft nach dem Zeitpunkt t1 ebenfalls nach unten. Die mathematische Funktion zur Bildung des Wartungs- und Prognosesignals wvs ist vorzugsweise derart gewählt, dass das Wartungs- und Prognosesignal wvs sich bei sprunghaften Änderungen der reflektierten Signalanteile rsa sowie des Messwertverlaufs mwv weniger stark ändert. Hierdurch werden Messfehler oder kurzzeitige Störungen nicht übergewichtet. Zum Zeitpunkt t2 z.B. treten kurzzeitig höhere Reflexionen auf, die zur

Überschreitung des ersten Schwellenwerts th1 führen. Die Reflexionen klingen jedoch schnell ab, weshalb keine Aktion ausgelöst wird und auch keine grosse Änderung für das Wartungs- und Prognosesignals wvs berechnet wird.

Zum Zeitpunkt t3 erreicht das Wartungs- und Prognosesignal wvs den Schwellwert th3, welcher anzeigt, dass die elektrische Leitung 1 gewechselt werden sollte, obwohl der Verlauf der reflektierten Signalanteile rsa den ersten Schwellenwert th1 noch nicht überschritten und der Messwertverlauf mwv den zweiten Schwellwert noch nicht unterschritten hat. Die elektrische Leitung eines wurde noch nicht ausgetauscht, sodass erst zum Zeitpunkt t4 der erste Schwellwert th1 überschritten und der zweite Schwellwert th2 unterschritten wurde. Schraffiert ist gezeigt, dass nach dem dritten Zeitpunkt t3 noch ein Notbetrieb möglich ist und das unterschreiten des Dritten Schwellenwerts des Wartungs- und Prognosesignal wvs eine wertvolle Vorwarnung darstellt. Das Wartungs- und Prognosesignal wvs kann daher vorteilhaft zur automatisierten Auslösung einer Bestellung verwendet werden, wenn das Wartungs- und Prognosesignal wvs unter den dritten Schwellwert th3 fällt.

### Bezugszeichen- und Abkürzungsliste

- Bfr: Bitfehlerrate
- dp: Datenpaket
- dg: zeitlicher Abstand, Intervall
- DSP: Signalprozessor
- DTP: Datenübertragungsprotokoll
- fp: Parameter, Stellgrössen
- L: Restlebensdauer
- mp: Messimpuls
- mwv: Messwertverlauf
- R: Reflexionsstelle
- RA: Amplitude der reflektierten Signalanteile
- rsa: reflektierte Signalanteile
- rx: empfangene Signale
- sg: Signalgüte
- SQ: Signalqualität
- t: Zeit
- tkt: Taktsignal
- t1: Schadenszeitpunkt
- t2: Zeitpunkt einer nicht relevanten Störung
- t3: Warnung für das Ende der Lebensdauerende der Leitung
- t4: Zeitpunkt des Eintretens der Fehlfunktionen
- th1: erster Schwellenwert für die ersten Messwerte
- th2: zweiter Schwellwert für die zweite Messwerte
- th3: dritter Schwellwert für das Prognosesignal wvs
- tx: Triggersignal für Messimpulse
- wvs: Wartungs- und Prognosesignal
- z: Messwert
- 1: elektrische Leitung
- 2: Datenstrom
- 41, 42: Datenendgeräte
- 5: Steuereinheit, vorzugsweise Mikrocontroller
- 6: Messschaltung
- 611: Sendeeinheit
- 612: Empfangseinheit
- 62: Transfereinheit
- 7A, 7B: Pegelwandler
- 8A, 8B: Steckbuchse
- 9: Messvorrichtung
- 90: Personalcomputer

## Patentansprüche

1. Verfahren zur Ermittlung des Zustands einer elektrischen Leitung (1) mittels einer Messvorrichtung (9) während des Nutzbetriebs, in dem Daten gemäss einem Datenübertragungsprotokoll (DTP) unidirektional oder bidirektional über die elektrische Leitung (1) übertragen werden, wobei
a) gemäss dem Datenübertragungsprotokoll Daten in Datenpaketen (dp) gebündelt werden, die in zeitlichen Abständen (dg) getrennt voneinander über die elektrische Leitung (1) übertragen werden;
b) während den zeitlichen Abständen (dg) wenigstens ein Messimpuls (mp) über die elektrische Leitung (1) übertragen wird;
c) innerhalb eines Zeitfensters Signalanteile (rsa) des Messimpulses (mp) gemessen werden, die an Reflexionsstellen (R) der elektrischen Leitung (1) reflektiert wurden;
d) die reflektierten Signalanteile (rsa) ausgewertet und für zumindest eine zugehörige Reflexionsstelle oder Schadstelle ein dazu entsprechender Zustand der elektrischen Leitung (1) bestimmt wird; und
dass aus den gemessenen reflektierten Signalanteilen (rsa) oder aus den gemäss Datenübertragungsprotokoll (DTP) übertragenen Daten oder aus Parametern (fp) einer Datenübertragungseinrichtung wenigstens ein zweiter Messwert, wie die Signalgüte, die Bitfehlerrate oder eine Stellgrösse eines Filters oder eines Regenerators abgeleitet wird; **dadurch gekennzeichnet,**
**dass** anhand der gemessenen reflektierten Signalanteile (rsa) oder des Verlaufs der gemessenen reflektierten Signalanteile (rsa) und anhand von zweiten Messwerten (sg, bfr, fp) oder des Verlaufs der zweiten Messwerte (sg, bfr, fp) ein Wartungs- und Prognosesignal (wvs) für die elektrische Leitung (1) gebildet wird, wobei das Wartungs- und Prognosesignal (wvs) eine mathematische Funktion ist, die zeitkontinuierlich berechnet wird.

2. Verfahren nach Anspruch 1, **dadurch gekennzeichnet, dass** während den zeitlichen Abständen (dg) innerhalb einer Sequenz von Datenpaketen (dp) und innerhalb eines Zeitfensters je wenigstens ein Messimpuls (mp) über die elektrische Leitung (1) übertragen und korrespondierende Signalanteile (rsa) des Messimpulses (mp) gemessen werden, die an Reflexionsstellen (R) der elektrischen Leitung (1) reflektiert wurden.

3. Verfahren nach Anspruch 1 oder 2, **dadurch gekennzeichnet, dass** die Laufzeiten der reflektierten Signalanteile (rsa) gemessen werden und anhand der gemessenen Laufzeiten die Position wenigstens einer korrespondierenden Reflexionsstelle (R) bestimmt wird.

4. Verfahren nach einem der Ansprüche 1, 2 oder 3, **dadurch gekennzeichnet, dass** der zeitliche Verlauf einer Kenngrösse der gemessenen reflektierten Signalanteilen (rsa), wie der Amplitudenverlauf, registriert wird und/oder dass der zeitliche Verlauf der zweiten Messwerte (sg, bfr, fp) registriert wird.

5. Verfahren nach einem der Ansprüche 1 - 4, **dadurch gekennzeichnet, dass** die gemessenen Signalanteile (rsa) oder deren zeitlicher Verlauf mit einem ersten Schwellwert (th1) verglichen werden und dass für die reflektierten Signalanteile (rsa), die den ersten Schwellenwert (th1) überschreiten, die korrespondierenden Laufzeiten ermittelt und die entsprechenden Positionen der Reflexionsstellen (R) in der elektrischen Leitung (1) bestimmt werden.

6. Verfahren nach einem der Ansprüche 1 - 5, **dadurch gekennzeichnet, dass** die wenigstens einen zweiten Messwerte (sg, bfr, fp) oder deren zeitlicher Verlauf mit einem zweiten Schwellwert (th2) verglichen werden, welcher eine ungenügende Qualität der zweiten Messwerte anzeigt, und/oder dass das Wartungs- und Prognosesignal (wvs) mit einem dritten Schwellwert verglichen wird, welcher dem Ende der Lebensdauer der elektrischen Leitung entspricht.

7. Verfahren nach einem der Ansprüche 1 - 6, **dadurch gekennzeichnet, dass** ein fehlertolerantes Datenübertragungsprotokoll angewendet wird, welches den Verlust wenigstens eines Datenpakets (dp) innerhalb einer Sequenz von mehreren Datenpaketen (dp) toleriert.

8. Verfahren nach einem der Ansprüche 1 - 7, **dadurch gekennzeichnet, dass** das Verfahren zur Zustandsbestimmung der elektrischen Leitung (1) und das Datenübertragungsverfahren gemäss dem Datenübertragungsprotokoll (DTP) zumindest für eine Zeitperiode, innerhalb der eine Messung der elektrischen Leitung (1) durchgeführt wird und Messimpulse (mp) gesendet werden, vorzugsweise gestützt auf das Datenübertragungsprotokoll (DTP) miteinander synchronisiert werden.

9. Verfahren nach einem der Ansprüche 1 - 8, **dadurch gekennzeichnet, dass** die übertragenen Datenpakete (dp) in der Messvorrichtung (9) geprüft werden, um die zweiten Messwerte und/oder Taktsignale zur Synchronisierung des Messprozesses zu ermitteln.

10. Verfahren nach einem der Ansprüche 1 - 9, **dadurch gekennzeichnet, dass** die Länge der Messpulse (mp) in einem Bereich von 5ns - 50ns liegt.

11. Messvorrichtung ausgebildet zur Durchführung des Verfahrens nach einem der Ansprüche 1 - 10.

12. Messvorrichtung (9) nach Anspruch 11, **dadurch gekennzeichnet, dass** eine Messschaltung (6) mit einer Steuereinheit (5), gegebenenfalls eine Mikroprozessor oder eine Signalprozessor, vorgesehen ist, mittels der eine Sendeeinheit (611) zur Abgabe der Messimpulse (mp) steuerbar ist und mittels der von einer Empfangseinheit (612) übertragene reflektierte Signalanteile (rsa) auswertbar sind.

13. Messvorrichtung (9) nach Anspruch 11 oder 12, **dadurch gekennzeichnet, dass** die Steuereinheit (5) oder eine Transfereinheit (62) zur Auswertung der gemäss dem Datenübertragungsprotokoll (DTP) übertragenen Daten und zur Ermittlung von Messwerten bezüglich der Signalqualität geeignet ist.

## Claims

1. Method for determining the state of an electric line (1) by means of a measurement device (9) during operational use, in which data is transmitted unidirectionally or bidirectionally via the electric line (1) in accordance with a data transmission protocol (DTP), wherein
a) according to the data transmission protocol, data is bundled into data packets (dp) which are transmitted separately from each other at time intervals (dg) via the electric line (1);
b) at least one measurement pulse (mp) is transmitted via the electric line (1) during the time intervals (dg);
c) within a time window, signal components (rsa) of the measurement pulse (mp) are measured which were reflected at reflection points (R) of the electric line (1) ;
d) the reflected signal components (rsa) are evaluated, and a corresponding state of the electric line (1) is determined for at least one associated reflection point or damage location; and
that from the measured reflected signal components (rsa) or from the data transmitted according to the data transmission protocol (DTP) or from parameters (fp) of a data transmission device at least one second measurement value, such as the signal quality, the bit error rate or a control variable of a filter or of a regenerator is derived; **characterised in,**
**that** on the basis of the measured reflected signal components (rsa) or the course of the measured reflected signal components (rsa) and on the basis of second measurement values (sg, bfr, fp) or the course of the second measurement values (sg, bfr, fp) a maintenance and prognosis signal (wvs) is formed for the electric line (1), wherein the maintenance and prognosis signal (wvs) is a mathematical function which is calculated continuously in time.

2. Method according to claim 1, **characterised in, that** during the time intervals (dg) within a sequence of data packets (dp) and within a time window at least one measurement pulse (mp) is transmitted via the electric line (1) and corresponding signal components (rsa) of the measurement pulse (mp) reflected at reflection points (R) of the electric line (1) are measured.

3. Method according to claim 1 or 2, **characterised in, that** the travel times of the reflected signal components (rsa) are measured and the position of at least one corresponding reflection point (R) is determined based on the measured travel times.

4. Method according to one of the claims 1, 2 or 3, **characterised in, that** the temporal course of a parameter of the measured reflected signal components (rsa), such as the amplitude course, is registered and/or that the temporal course of the second measured values (sg, bfr, fp) is registered.

5. Method according to one of the claims 1 - 4, **characterised in, that** the measured signal components (rsa) or their temporal course are compared with a first threshold value (th1) and that for the reflected signal components (rsa) exceeding the first threshold value (th1) the corresponding transit times are determined and the corresponding positions of the reflection points (R) in the electric line (1) are determined.

6. Method according to one of the claims 1 - 5, **characterised in, that** the at least one second measurement values (sg, bfr, fp) or their time course are compared with a second threshold value (th2) indicating an insufficient quality of the second measurement values, and/or that the maintenance and prognosis signal (wvs) is compared with a third threshold value corresponding to the end of life of the electric line.

7. Method according to one of the claims 1 - 6, **characterised in, that** a fault tolerant data transmission protocol is applied which tolerates the loss of at least one data packet (dp) within a sequence of multiple data packets (dp).

8. Method according to one of the claims 1 - 7, **characterised in, that** the method for determining the state of the electric line (1) and the data transmission method according to the data transmission protocol (DTP) are synchronized with each other, preferably based on the data transmission protocol (DTP), at least for a time period within which a measurement of the electric line (1) is performed and measurement pulses (mp) are transmitted.

9. Method according to one of the claims 1 - 8, **characterised in, that** the transmitted data packets (dp) are examined in the measurement device (9) to determine the second measurement values and/or clock signals for synchronization of the measurement process.

10. Method according to one of the claims 1 - 9, **characterised in, that** the length of the measurement pulses (mp) is in a range of 5ns - 50ns.

11. Measurement device (9) for implementing the method according to one of the claims 1 - 10.

12. Measurement device (9) according to claim 11, **characterised in, that** a measurement circuit (6) with a control unit (5), possibly a microprocessor or a signal processor, is provided, by means of which a transmitting unit (611) for emitting the measurement pulses (mp) is controllable and by means of which reflected signal components (rsa) transferred by a receiving unit (612) can be evaluated.

13. Measurement device (9) according to claim 11 or 12, **characterised in, that** the control unit (5) or a transfer unit (62) is suitable for evaluating the data transmitted according to the data transmission protocol (DTP) and for determining measurement values with respect to the signal quality.

## Revendications

1. Procédé pour déterminer l'état d'une ligne électrique (1) au moyen d'un dispositif de mesure (9) pendant le cours de l'utilisation, dans lequel des données sont transmises de manière unidirectionnelle ou bidirectionnelle par la ligne électrique (1) conformément à un protocole de transmission de données (DTP), dans lequel
a) selon le protocole de transmission de données, des données sont concentrées dans des paquets de données (dp) qui sont transmis séparément les uns des autres à des intervalles de temps (dg) par la ligne électrique (1) ;
b) pendant les intervalles de temps (dg), au moins une pulsation de mesure (mp) est transmise par la ligne électrique (1);
c) dans une fenêtre de temps, des composantes de signal (rsa) de la pulsation de mesure (mp) sont mesurées, qui ont été réfléchies sur des points de réflexion (R) de la ligne électrique (1);
d) les composantes de signal (rsa) réfléchies sont évaluées et un état de la ligne électrique (1) correspondant à celles-ci est déterminé pour au moins un point de réflexion ou point défectueux associé; et
en ce à partir des composantes de signal réfléchies mesurées (rsa) ou à partir des données transmises selon le protocole de transmission de données (DTP) ou à partir de paramètres (fp) d'un dispositif de transmission de données, au moins une deuxième valeur de mesure, telle que la qualité du signal, le taux d'erreur sur les bits ou une grandeur de réglage d'un filtre ou d'un régénérateur, est déduite; **caractérisé en ce que**
à l'aide des composantes de signal (rsa) réfléchies mesurées ou de l'évolution des composantes de signal (rsa) réfléchies mesurées et à l'aide de deuxièmes valeurs de mesure (sg, bfr, fp) ou de l'évolution des deuxièmes valeurs de mesure (sg, bfr, fp), un signal de maintenance et de pronostic (wvs) est formé pour la ligne électrique (1), dans lequel le signal de maintenance et de pronostic (wvs) est une fonction mathématique qui est calculée en continu dans le temps.

2. Procédé selon la revendication 1, **caractérisé en ce que** pendant les intervalles de temps (dg), dans une séquence de paquets de données (dp) et dans une fenêtre temporelle, au moins une pulsation de mesure (mp) est transmise par la ligne électrique (1) et des composantes de signal (rsa) correspondantes de la pulsation de mesure (mp) réfléchies aux points de réflexion (R) de la ligne électrique (1) sont mesurées.

3. Procédé selon la revendication 1 ou 2, **caractérisé en ce que** les temps de course des composantes de signal (rsa) réfléchies sont mesurés et que la position d'au moins un point de réflexion (R) correspondant est déterminée à l'aide des temps de course mesurés.

4. Procédé selon une des revendications 1, 2 ou 3, **caractérisé en ce que** l'évolution dans le temps d'une grandeur caractéristique des composantes de signal (rsa) réfléchies mesurées, telle que l'évolution de l'amplitude, est enregistrée et/ou **en ce que** l'évolution dans le temps des deuxièmes valeurs de mesure (sg, bfr, fp) est enregistrée.

5. Procédé selon une des revendications 1 - 4, **caractérisé en ce que** les composantes de signal (rsa) mesurées ou leur évolution dans le temps sont comparées à une première valeur de seuil (th1) et **en ce que**, pour les composantes de signal (rsa) réfléchies qui dépassent la première valeur de seuil (th1), les temps de course correspondants sont déterminés et les positions correspondantes des points de réflexion (R) dans la ligne électrique (1) sont déterminées.

6. Procédé selon une des revendications 1 - 5, **caractérisé en ce que** les au moins une deuxième valeurs de mesure (sg, bfr, fp) ou leur évolution dans le temps sont comparées à une deuxième valeur de seuil (th2) qui indique une qualité insuffisante des deuxièmes valeurs de mesure, et/ou **en ce que** le signal de maintenance et de pronostic (wvs) est comparé à une troisième valeur de seuil qui correspond à la fin de la durée de vie de la ligne électrique.

7. Procédé selon une des revendications 1 - 6, **caractérisé en ce qu'**on utilise un protocole de transmission de données tolérant les erreurs, qui tolère la perte d'au moins un paquet de données (dp) dans une séquence de plusieurs paquets de données (dp).

8. Procédé selon une des revendications 1 - 7, **caractérisé en ce que** le procédé de détermination de l'état de la ligne électrique (1) et le procédé de transmission de données selon le protocole de transmission de données (DTP) sont synchronisés entre eux, de préférence sur la base du protocole de transmission de données (DTP), au moins pour une période de temps pendant laquelle une mesure de la ligne électrique (1) est effectuée et des pulsations de mesure (mp) sont envoyées.

9. Procédé selon une des revendications 1 - 8, **caractérisé en ce que** les paquets de données (dp) transmis sont vérifiés dans le dispositif de mesure (9) afin de déterminer les deuxièmes valeurs de mesure et/ou les signaux d'horloge pour la synchronisation du processus de mesure.

10. Procédé selon une des revendications 1 - 9, **caractérisé en ce que** la longueur des impulsions de mesure (mp) se situe dans une zone de 5ns - 50ns.

11. Dispositif de mesure adapté à la mise en œuvre du procédé selon l'une des revendications 1 - 10.

12. Dispositif de mesure (9) selon la revendication 11, **caractérisé en ce qu'**il est prévu un circuit de mesure (6) avec une unité de commande (5), éventuellement un microprocesseur ou un processeur de signaux, au moyen duquel une unité d'émission (611) peut être commandée pour l'émission des pulsations de mesure (mp) et au moyen duquel des composantes de signal réfléchies (rsa) transférées par une unité de réception (612) peuvent être évaluées.

13. Dispositif de mesure (9) selon la revendication 11 ou 12, **caractérisé en ce que** l'unité de commande (5) ou une unité de transfert (62) est appropriée pour l'évaluation des données transmises selon le protocole de transmission de données (DTP) et pour la détermination de valeurs de mesure concernant la qualité du signal.
